# EUROPEAN PATENT SPECIFICATION

(11) **EP 4 144 529 B1**
(45) Date of publication and mention of the grant of the patent: **17.09.2025**
(21) Application number: 20933556.1
(22) Date of filing: 01.05.2020
(51) Int. Cl.: B32B 38/18, B32B 37/12

(54) **BONDING DEVICE AND BONDING METHOD**
VERBINDUNGSVORRICHTUNG UND VERBINDUNGSVERFAHREN
DISPOSITIF DE COLLAGE ET PROCÉDÉ DE COLLAGE

(43) Date of publication of application: 08.03.2023
(73) Proprietor: Climb Products Co., Ltd., Osaka 540-0005 (JP)
(72) Inventor: KOMODA Daisuke, Osaka-shi Osaka 540-0005 (JP)
(74) Representative: Plougmann Vingtoft a/s
(86) International application number: PCT/JP2020/018386
(87) International publication number: WO 2021/220504

(56) References cited:
- WO-A1-2018/198194
- CN-U- 205 819 648
- JP-A- 2001 138 482
- JP-A- 2010 094 910
- JP-A- 2011 194 607
- JP-A- 2013 139 108
- JP-A- 2015 039 862
- JP-A- 2015 167 214
- US-A1- 2017 255 033

## Description

### TECHNICAL FIELD

The present invention relates to a bonding device and a bonding method for bonding a pair of workpieces having a two-dimensional planar shape in which a protruding curved surface and a recessed curved surface are continuous.

### BACKGROUND ART

As for a bonding device for obtaining a bonded body by bonding a pair of workpieces, the present applicant has previously proposed a bonding device of Patent Literature 1. The bonding device of Patent Literature 1 includes an upper suction base that sucks and holds a first workpiece, and a group of lower suction bases that suck and hold a second workpiece. The lower suction base is provided with a bonding roller that bonds the second workpiece to the first workpiece, an elevating structure to moves the bonding roller up and down, a roller moving structure that laterally moves the bonding roller from a bonding start end toward a bonding stop end, and the like. At the time of bonding both the workpieces, the second workpiece is bonded to the first workpiece while retracting the lower suction bases from a lateral movement region of the bonding roller one after another in a state where the bonding start end of the second workpiece is pressed and held by the bonding roller.

### CITATIONS LIST

### PATENT LITERATURE

Patent Literature 1: JP 2015-39862 A

### SUMMARY OF INVENTION

### TECHNICAL PROBLEMS

According to the bonding device of Patent Literature 1, since the pair of workpieces are bonded in a state of being sucked and held in, for example, a protruding curved surface shape, both the workpieces can be appropriately bonded. However, the bonding can be performed with high accuracy only when the bonding surface of each workpiece is a simple protruding curved surface or a concave curved surface, and when the bonding surface is a concavo-convex curved surface in which the protruding curved surface and the concave curved surface are continuous, the bonding accuracy is limited. This is because, when a workpiece having self-shape retainability such as a glass substrate, and a workpiece having no self-shape retainability such as a functional sheet are bonded to each other, the latter (functional sheet) cannot be accurately retainable in a concavo-convex curved surface shape, and as a result, it is difficult to correctly position both the workpieces. More specifically, in the bonding device of Patent Literature 1, even if the functional sheet is placed and positioned on a suction screen in a state where the group of lower suction bases are lowered, when the functional sheet is sucked and held by raising the lower suction bases to a suction position, suction timings of the individual lower suction bases are shifted, and it is inevitable that the functional sheet is shifted. Therefore, in the bonding device of Patent Literature 1, when the bonding surface is a concavo-convex curved surface in which a protruding curved surface and a concave curved surface are continuous, the bonding accuracy of both the workpieces is limited, and there is room for improvement in this point.

An object of the present invention is to provide a bonding device and a bonding method capable of precisely positioning both workpieces and bonding both workpieces more accurately even when a bonding surface of each workpiece includes a concavo-convex curved surface in which a protruding curved surface and a recessed curved surface are continuous.

### SOLUTIONS TO PROBLEMS

A bonding device according to the present invention includes an upper suction board 1 including an upper suction base 4 that sucks and holds a first workpiece W1, and a lower suction board 2 including a lower suction base 6 that sucks and holds a second workpiece W2. In the upper suction base 4, a suction base 14 for sucking and holding the first workpiece W1 molded, in advance, including a concavo-convex curved shape in which a protruding curved surface and a recessed curved surface are continuous is formed. The lower suction base 6 is provided with a fixed suction base 16 having a frame structure fixed to a base 5, a movable suction base 17 having a frame structure disposed around the fixed suction base 16, and a suction screen 8 covering an upper opening surface of the movable suction base 17. The movable suction base 17 is configured to be vertically movable between a workpiece supporting position where its upper opening surface is located above an upper opening surface of the fixed suction base 16 and the second workpiece W2 on the suction screen 8 is sucked and held in a flat posture, and a workpiece transfer position where the upper opening surface is lowered below the upper opening surface of the fixed suction base 16 and the suction screen 8 is supported by the upper opening surface of the fixed suction base 16. A concavo-convex curved part 18 corresponding to the concavo-convex curved shape of the first workpiece W1 is formed in a peripheral frame part of the fixed suction base 16, and in a state where the movable suction base 17 is lowered to the workpiece transfer position, the second workpiece W2 supported in a flat posture by the suction screen 8 is sucked and held in a concavo-convex curved shape via the suction screen 8 deformed exactly along the concavo-convex curved part 18. In a state where the first workpiece W1 sucked and held by the upper suction base 4 and the second workpiece W2 sucked and held by the lower suction base 6 face each other vertically, the second workpiece W2 is pressed against the first workpiece W1 by a bonding roller 7 provided inside the fixed suction base 16, and, in this state, the bonding roller 7 is moved from a bonding start end to a bonding stop end while being moved up and down along the concavo-convex curved shape of the first workpiece W1, whereby the first workpiece W1 and the second workpiece W2 are bonded.

The fixed suction base 16 and the movable suction base 17 are each formed in a square frame shape. The concavo-convex curved part 18 is formed on each side part of one of facing side parts, out of four peripheral side parts constituting the fixed suction base 16, and a stretching structure that stretches and holds the suction screen 8 is disposed outside the facing side parts. The stretching structure includes a first stretching structure that stretches the suction screen 8 in a direction parallel to a bonding movement direction of the bonding roller 7, and a second stretching structure that stretches the suction screen 8 in a direction orthogonal to the bonding movement direction of the bonding roller 7. The second stretching structure includes a slide stand 23 that is guided and supported by the base 5 so as to be able to slide back and forth, a slider 24 that is guided and supported by the slide stand 23 so as to be able to slide up and down, an elevating cylinder 25 that performs an elevating operation of the slider 24 to stretch the suction screen 8, and a connecting structure 26 that is mounted on the slider 24 and fixedly holds an end part of the suction screen 8. The connecting structure 26 includes a tilting block 34 tiltably supported by the slider 24, and a fastener 35 that cooperates with the tilting block 34 to sandwich and fix the suction screen 8. The suction screen 8 is deformed into a concavo-convex curved shape following the concavo-convex curved shape of the concavo-convex curved part 18, and the second workpiece W2 sucked and held by the suction screen 8 is deformed into the concavo-convex curved shape of the concavo-convex curved part 18 along with the deformation of the suction screen 8. In addition, it is configured that the tilting block 34 facing the concavo-convex curved part 18 tilts and the slide stand 23 slides in a front-rear direction along with the deformation of the suction screen 8.

A tilting shaft 36 of the tilting block 34 is tiltably and pivotally supported by a bearing part 33 provided in an upper part of the slider 24. A thrust bearing 38 that receives a stretching force of the suction screen 8 is disposed between the bearing part 33 and the tilting block 34.

A roller moving structure for moving the bonding roller 7 between the bonding start end and the bonding stop end is provided inside the fixed suction base 16. The roller moving structure includes a roller base 42 that is movably guided by a guide rail 41 fixed to the base 5, a drive screw shaft 43 that is disposed in parallel with the guide rail 41 and rotatably supported by the base 5, a motor 44 that drives the drive screw shaft 43 forward and in reverse, and a female screw body 45 that is mounted on the roller base 42 and meshes with the drive screw shaft 43.

Between a roller base 47 that rotatably supports the bonding roller 7 and the roller base 42, a roller elevating and lowering structure that elevates and lowers the bonding roller 7 following the concavo-convex curved shape of the first workpiece W1 is provided. The roller elevating and lowering structure includes a roller base 47 slidably guided by a vertical guide rail 48 of the roller base 42, an elevating and lowering table 50 fixed to the roller base 42, a motor 51 fixed to the elevating and lowering table 50, an elevating and lowering screw shaft 52 driven forward and in reverse by the motor 51, and a female screw body 53 mounted on the roller base 47 and meshing with the elevating and lowering screw shaft 52.

Along an outer surface of a side part of the movable suction base 17 facing the concavo-convex curved part 18, a group of shielding plates 56 that prevent outside air from entering an inside of the fixed suction base 16 are disposed. Each of the shielding plates 56 is swingably suspended by a bracket 57 mounted on the suction screen 8 via a support shaft 58. It is configured that a gap between the upper opening surface of the movable suction base 17 facing the concavo-convex curved part 18 and the suction screen 8 is closed by the shielding plate 56 in a state where the movable suction base 17 is lowered to the workpiece transfer position.

Adjacent ends of the adjacent shielding plates 56 overlap each other inside and outside. In a state where the movable suction base 17 is lowered to the workpiece transfer position, the group of shielding plates 56 are suspended in a vertical posture by the support shaft 58, and the gap between the upper opening surface of the movable suction base 17 and the suction screen 8 is closed in a state where the adjacent ends of the shielding plates 56 overlap each other inside and outside.

A bonding method according to the present invention includes the steps of: sucking and holding a first workpiece W1 molded in advance into a concavo-convex curved shape in which a protruding curved surface and a concave curved surface are continuous by an upper suction base 4, and placing a second workpiece W2 on a suction screen 8 supported flat by a movable suction base 17 moved to a workpiece supporting position and sucking and holding the second workpiece W2; moving the movable suction base 17 downward to a workpiece transfer position to deform the suction screen 8 into a concavo-convex curved shape following a concavo-convex curved shape of a concavo-convex curved part 18 formed on a fixed suction base 16, and deforming the second workpiece W2 sucked and held by the suction screen 8 into the concavo-convex curved shape of the concavo-convex curved part 18 accompanying the deformation of the suction screen 8; causing the upper suction base 4 and a lower suction base 6 to vertically face each other to match the concavo-convex curved shapes of the first workpiece W1 and the second workpiece W2, and keeping a facing interval between the workpieces W1 and W2 constant along the concavo-convex curved shapes; and bonding the second workpiece W2 to the first workpiece W1 by moving a bonding roller 7 provided inside the fixed suction base 16 from a bonding start end toward a bonding stop end by a roller moving structure in a state where the second workpiece W2 is pressed against the first workpiece W1 by elevating the bonding roller 7 from a standby position to a pressing position by a roller elevating and lowering structure. In the step of bonding the second workpiece W2 to the first workpiece W1, the bonding roller 7 is elevated and lowered along the concavo-convex curved shape of the first workpiece W1 by the roller elevating and lowering structure to bond the second workpiece W2 to the first workpiece W1 with a uniform pressing force.

### ADVANTAGEOUS EFFECTS OF INVENTION

In the bonding device of the present invention, the lower suction base 6 of the lower suction board 2 is provided with the fixed suction base 16 having a frame structure, and the movable suction base 17 having a frame structure disposed around the fixed suction base 16. Further, the movable suction base 17 is configured to be vertically movable between the workpiece supporting position where the upper opening surface is located above the upper opening surface of the fixed suction base 16 and the second workpiece W2 on the suction screen 8 is sucked and held in a flat posture and the workpiece transfer position where the upper opening surface is lowered below the upper opening surface of the fixed suction base 16 and the suction screen 8 is supported by the upper opening surface of the fixed suction base 16. Furthermore, in a state where the movable suction base 17 is lowered to the workpiece transfer position, the second workpiece W2 supported in a flat posture by the suction screen 8 is sucked and held in the concavo-convex curved shape via the suction screen 8 deformed exactly along the concavo-convex curved part 18, and in this state, the first workpiece W1 and the second workpiece W2 are bonded together.

As described above, in the bonding device according to the present invention, the second workpiece W2 is sucked and held in a flat posture on the suction screen 8 at the workpiece supporting position, and the second workpiece W2 is sucked and held in the concavo-convex curved shape via the suction screen 8 deformed exactly along the concavo-convex curved part 18 at the workpiece transfer position. Therefore, the second workpiece W2 can be deformed from the flat posture to the concavo-convex curved shape while the sucked and held state via the suction screen 8 is maintained in synchronization with the deformation of the suction screen 8 from the workpiece supporting position to the workpiece transfer position. As a result, it is possible to prevent a positional deviation from occurring between the suction screen 8 and the second workpiece W2, so that the workpieces W1 and W2 can be accurately bonded while being precisely positioned although the bonding surface of each of the workpieces W1 and W2 is formed to include a concavo-convex curved surface.

The stretching structure for stretching and holding the suction screen 8 includes the first stretching structure for stretching the suction screen 8 in a direction parallel to the bonding movement direction of the bonding roller 7, and the second stretching structure for stretching the suction screen 8 in a direction orthogonal to the bonding movement direction of the bonding roller 7. The second stretching structure includes the slide stand 23 that slides back and forth, the slider 24 that slides up and down with respect to the slide stand 23, the elevating cylinder 25 that elevates and lowers the slider 24, and the connecting structure 26 that fixedly holds the end part of the suction screen 8. The connecting structure 26 includes the tilting block 34 tiltably supported by the slider 24, and the fastener 35 that cooperates with the tilting block 34 to sandwich and fix the suction screen 8. Then, the suction screen 8 is deformed into the concavo-convex curved shape following the concavo-convex curved shape of the concavo-convex curved part 18, the second workpiece W2 sucked and held by the suction screen 8 is deformed into the concavo-convex curved shape of the concavo-convex curved part 18 along with the deformation of the suction screen 8, and in addition, the tilting block 34 facing the concavo-convex curved part 18 tilts along with the deformation of the suction screen 8, and the slide stand 23 slides in the front-rear direction. According to this, since the tilting block 34 can be tilted and the slide stand 23 can be slid while being dependent on the deformation of the suction screen 8, the suction screen 8 can be deformed into the concavo-convex curved shape while applying an appropriate stretching force to the suction screen 8. In other words, it is possible to deform the suction screen 8 into the concavo-convex curved shape while applying an appropriate stretching force to the suction screen 8 such that wrinkles and slack do not occur and excessive stress is not applied.

When the tilting shaft 36 of the tilting block 34 is tiltably and pivotally supported by the bearing part 33 in the upper part of the slider 24, and the thrust bearing 38 that receives the stretching force of the suction screen 8 is disposed between the bearing part 33 and the tilting block 34, the stretching force of the suction screen 8 acting on the tilting block 34 can be received and released by the thrust bearing 38. Therefore, it is possible to suppress application of excessive stress to the suction screen 8 and to apply an appropriate stretching force to the suction screen 8.

When the roller moving structure for moving the bonding roller 7 between the bonding start end and the bonding stop end is provided inside the fixed suction base 16, a roller moving speed when the bonding roller 7 moves up and down along the concavo-convex curved shape of the first workpiece W1 can be optimized only by controlling a driving rotation speed of the motor 44. Therefore, the second workpiece W2 can be uniformly and appropriately bonded to the first workpiece W1.

The roller elevating and lowering structure for elevating and lowering the bonding roller 7 according to the concavo-convex curved shape of the first workpiece W1 is provided between the roller base 47 and the roller base 42 that support the bonding roller 7, and the roller elevating and lowering structure includes the roller base 47 slidably guided by the vertical guide rail 48 of the roller base 42, the elevating and lowering table 50 fixed to the roller base 42, the motor 51 fixed to the elevating and lowering table 50, the elevating and lowering screw shaft 52 driven forward and in reverse by the motor 51, and the female screw body 53 mounted on the roller base 47. Therefore, the bonding roller 7 can be accurately elevated and lowered along the concavo-convex curved shape of the first workpiece W1 by the elevating and lowering structure, so that the second workpiece W2 can always be pressed against the first workpiece W1 with an even force, and the bonding of both the workpieces W1 and W2 can always be appropriately performed.

When a group of the shielding plates 56 for preventing entry of outside air are disposed along the outer surface of the movable suction base 17 facing the concavo-convex curved part 18, and each of the shielding plates 56 is swingably suspended by the bracket 57 mounted on the suction screen 8 via the support shaft 58, the gap between the upper opening surface of the movable suction base 17 facing the concavo-convex curved part 18 and the suction screen 8 can be closed by the shielding plate 56 in a state where the movable suction base 17 is lowered to the workpiece transfer position. Therefore, in the state where the movable suction base 17 is lowered to the workpiece transfer position, the group of shielding plates 56 prevent the outside air from entering the inside of the lower suction base 6, and the second workpiece W2 can be appropriately and continuously sucked and held along the concavo-convex shape of the concavo-convex curved part 18.

When the adjacent ends of the adjacent shielding plates 56 overlap each other inside and outside, in a state where the movable suction base 17 is lowered to the workpiece transfer position, the group of shielding plates 56 are suspended in a vertical posture by the support shaft 58, and the gap between the upper opening surface of the movable suction base 17 and the suction screen 8 can be closed in a state where the adjacent ends of the shielding plates 56 overlap each other inside and outside. Further, since the shielding plates 56 are disposed in a state where the adjacent ends thereof overlap each other inside and outside, the space occupied by the shielding plates 56 can be made small and compact.

The bonding method according to the present invention includes the steps of: sucking and holding the first workpiece W1 molded into a concavo-convex curved shape by the upper suction base 4, and placing the second workpiece W2 on the suction screen 8 supported by the movable suction base 17 located at the workpiece supporting position and sucking and holding the second workpiece W2; moving the movable suction base 17 downward to the workpiece transfer position to deform the suction screen 8 into a concavo-convex curved shape following a concavo-convex curved shape of the concavo-convex curved part 18 formed on the fixed suction base 16, and deforming the second workpiece W2 sucked and held by the suction screen 8 into the concavo-convex curved shape of the concavo-convex curved part 18 accompanying the deformation of the suction screen 8; causing the upper suction base 4 and the lower suction base 6 to vertically face each other to match the concavo-convex curved shapes of the first workpiece W1 and the second workpiece W2, and keeping a facing interval between the workpieces W1 and W2 constant; and bonding the second workpiece W2 to the first workpiece W1 by elevating the bonding roller 7 provided inside the fixed suction base 16 by the roller elevating and lowering structure to press the second workpiece W2 against the first workpiece W1, and moving the bonding roller 7 toward the bonding stop end by the roller moving structure in this state. Further, in the step of bonding the second workpiece W2 to the first workpiece W1, the bonding roller 7 is elevated and lowered along the concavo-convex curved shape of the first workpiece W1 by the roller elevating and lowering structure to bond the second workpiece W2 to the first workpiece W1 with a uniform pressing force.

According to such a bonding method, the second workpiece W2 that is flat in a normal state can be sucked and held by the concavo-convex curved part 18 of the fixed suction base 16 exactly along the concavo-convex curved shape of the first workpiece W1, and thus both the workpieces W1 and W2 can be precisely positioned and bonded with high accuracy even though the bonding surfaces of the workpieces W1 and W2 are formed of the concavo-convex curved surfaces.

### BRIEF DESCRIPTION OF DRAWINGS

FIG. 1 is a longitudinal sectional front view of a bonding device according to the present invention in a state where an upper suction base is opened.
FIG. 2 is a plan view of the bonding device in a state where the upper suction base is opened.
FIG. 3 is a cross-sectional view taken along line A-A in FIG. 2.
FIG. 4 is an enlarged cross-sectional view of a part B in FIG. 1.
FIG. 5 is a longitudinal sectional front view illustrating a roller elevating and lowering structure.
FIG. 6 is a longitudinal sectional front view illustrating a connecting structure of an end part of a suction screen.
FIG. 7 is a plan view illustrating the connecting structure of the end part of the suction screen.
FIGS. 8A to 8D are explanatory views illustrating a procedure of bonding workpieces.
FIGS. 9A and 9B are explanatory views illustrating a suction state of the suction screen in a concavo-convex curved part.
FIG. 10 is an explanatory diagram illustrating a tilting operation of a tilting block.
FIG. 11 is a longitudinal sectional front view illustrating a shielding situation of shielding plates.
FIG. 12 is a side view illustrating the shielding situation of the shielding plates.

### DESCRIPTION OF EMBODIMENT

### (Example)

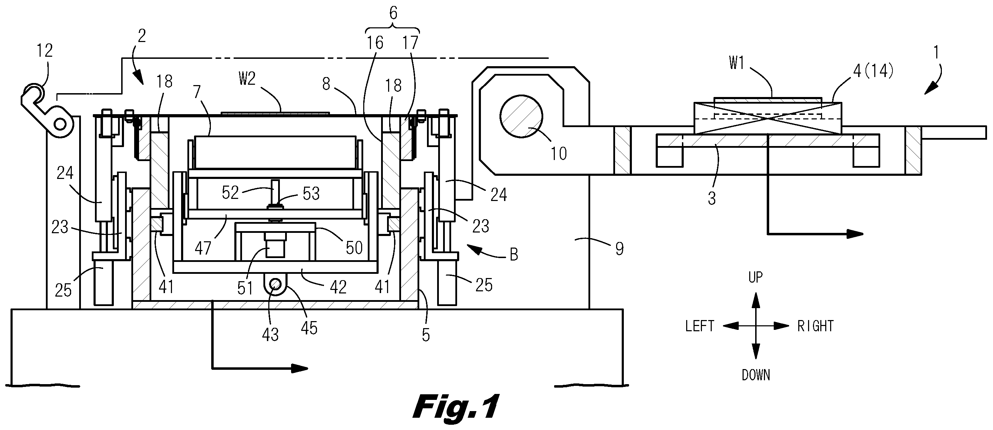

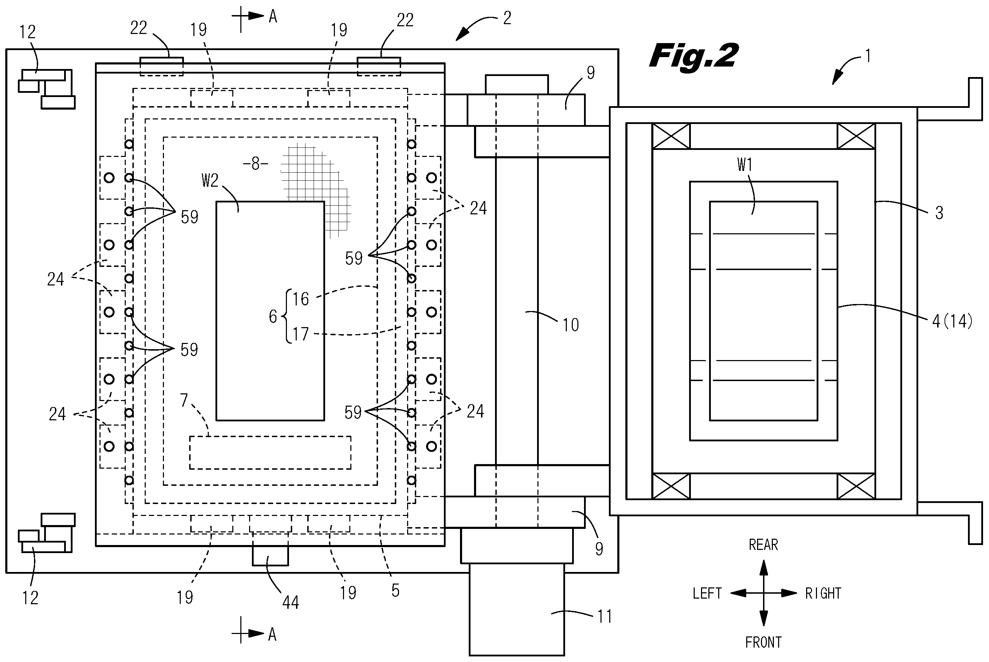

An example of a bonding device according to the present invention is shown in FIGS. 1 to 12. Front and rear, left and right, and up and down in the present example follow cross arrows shown in FIGS. 1 and 2 and the front and rear, left and right, and up and down notations in the vicinity of each arrow.

The bonding device includes an upper suction board 1 on a right side, and a lower suction board 2 on a left side in FIG. 1. An alignment table 3 is provided inside the upper suction board 1, and an upper suction base 4 that sucks and holds a first workpiece W1 is provided on an upper surface of the alignment table 3. The lower suction board 2 includes a base 5 having a square frame shape, and a lower suction base 6 that sucks and holds a second workpiece W2 is provided on an upper part of the base 5. Inside the base 5 and the lower suction base 6, a bonding roller 7 for bonding the second workpiece W2 to the first workpiece W1, a roller moving structure for moving the bonding roller 7 between a bonding start end and a bonding stop end, a roller elevating and lowering structure, and the like are provided. Further, a stretching structure for stretching a suction screen 8 covering an opening surface of the lower suction base 6 is provided around the base 5 and the lower suction base 6.

The upper suction board 1 is configured to be swingable and openable between an open position indicated by a solid line in FIG. 1 and a bonding position indicated by an imaginary line. Specifically, brackets 9 are fixed to the front and rear of a right outer side of the base 5, and a base end part of the upper suction board 1 is pivotally supported by an opening and closing shaft 10 pivotally supported by both the brackets 9. The opening and closing shaft 10 is rotationally driven by a geared motor 11 fixed to the front bracket 9. In order to fixedly hold the upper suction board 1 swung and moved to the bonding position, a closing frame is erected on the front and rear of a left outer side of the base 5, and a closing lock body 12 is provided on an upper part thereof. The first workpiece W1 in the present example is formed of a glass substrate molded in advance into a concavo-convex curved shape in which a protruding curved surface and a recessed curved surface are continuous, the second workpiece W2 is formed of a flat functional film such as a deflection sheet or an antireflection film, and a transparent adhesive is applied to a bonding surface (upper surface) with the first workpiece W1.

In FIGS. 1 and 2, the upper suction base 4 includes a hollow suction base 14 molded into a concavo-convex curved shape, and an inside of the suction base 14 is connected to a suction source (not illustrated) via an air passage, an electromagnetic valve, or the like. A group of suction holes for sucking and holding the first workpiece W1 is formed on a surface of the suction base 14. The first workpiece W1 is positioned by being placed on the suction base 14 in a state where the upper suction board 1 is in a horizontal open posture, and a vacuum pressure is applied to the inside of the suction base 14 in this state, whereby the first workpiece W1 can be sucked and fixed to the suction base 14.

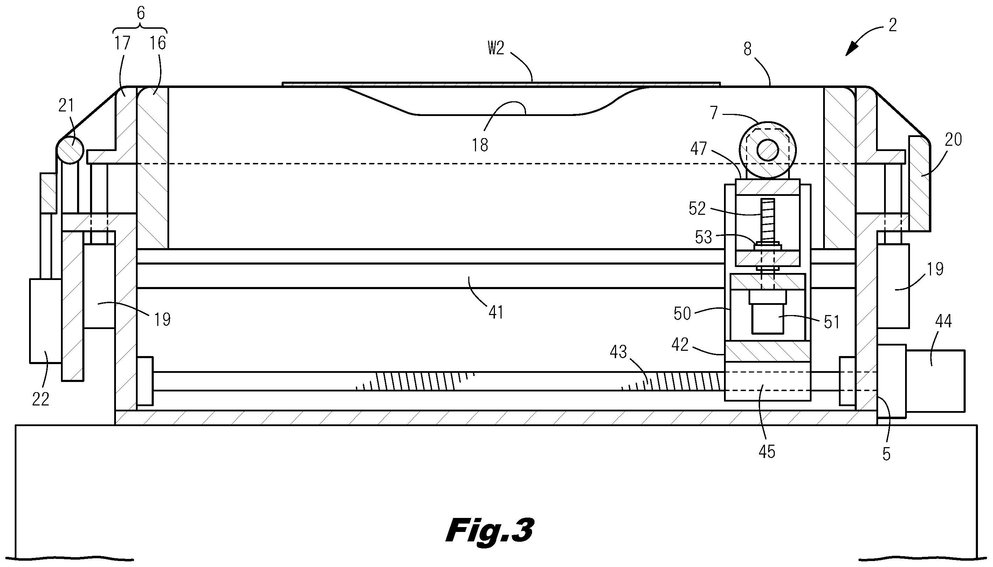

As illustrated in FIG. 3, the lower suction base 6 includes a fixed suction base 16 having a frame structure in which upper and lower surfaces fixed to the base 5 are opened, and a movable suction base 17 having a frame structure disposed around the fixed suction base 16. Similarly to the upper suction base 4, an inside of the lower suction base 6 is connected to a suction source (not illustrated) via an air passage, an electromagnetic valve, and the like. An upper opening surface of the movable suction base 17 is covered with the suction screen 8 described above. The suction screen 8 is formed of a sheet body in which a canvas material having a thickness of about 1 mm is impregnated with a resin, and a group of microholes are formed in a suction region of the second workpiece W2. A concavo-convex curved part 18 corresponding to the concavo-convex curved shape of the first workpiece W1 is formed on left and right opposing side parts (peripheral frame parts) of the fixed suction base 16.

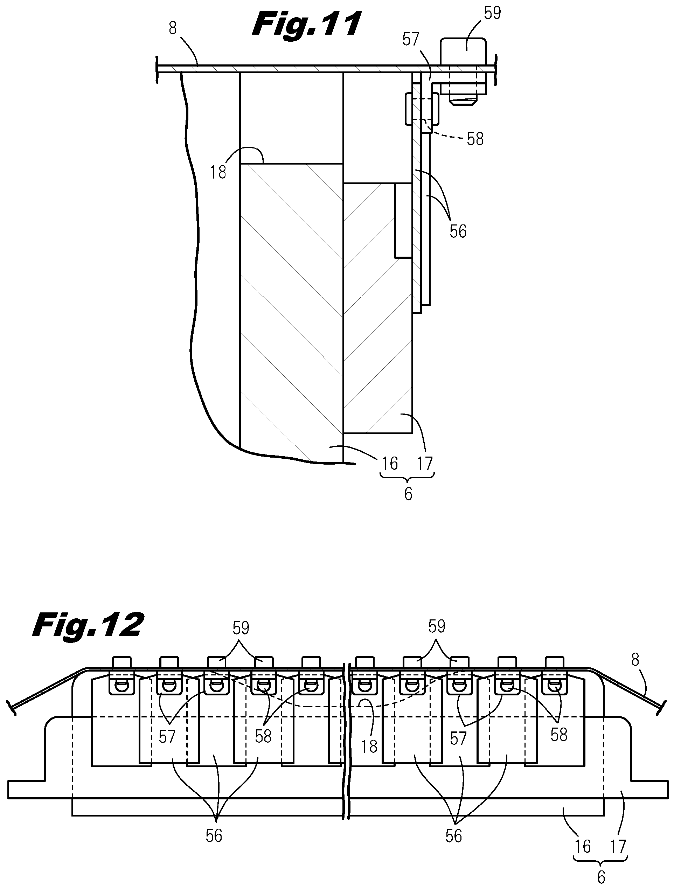

As illustrated in FIG. 3, by a pair of operation cylinders 19 provided on outer surfaces of front and back side parts of the base 5, the movable suction base 17 can move up and down between a workpiece supporting position where an upper opening surface thereof is flush with an upper opening surface of the fixed suction base 16 and a workpiece transfer position (state illustrated in FIG. 11) where the upper opening surface is lowered to a lower side of the upper opening surface of the fixed suction base 16. In a state where the movable suction base 17 is held at the workpiece supporting position, the second workpiece W2 is placed and positioned on the suction screen 8 and then sucked and held. Further, in a state where the upper opening surface of the movable suction base 17 is lowered to the workpiece transfer position below the concavo-convex curved part 18, the second workpiece W2 supported in a flat posture by the suction screen 8 is sucked and held in a state of matching the concavo-convex shape of the concavo-convex curved part 18. Details thereof will be described later.

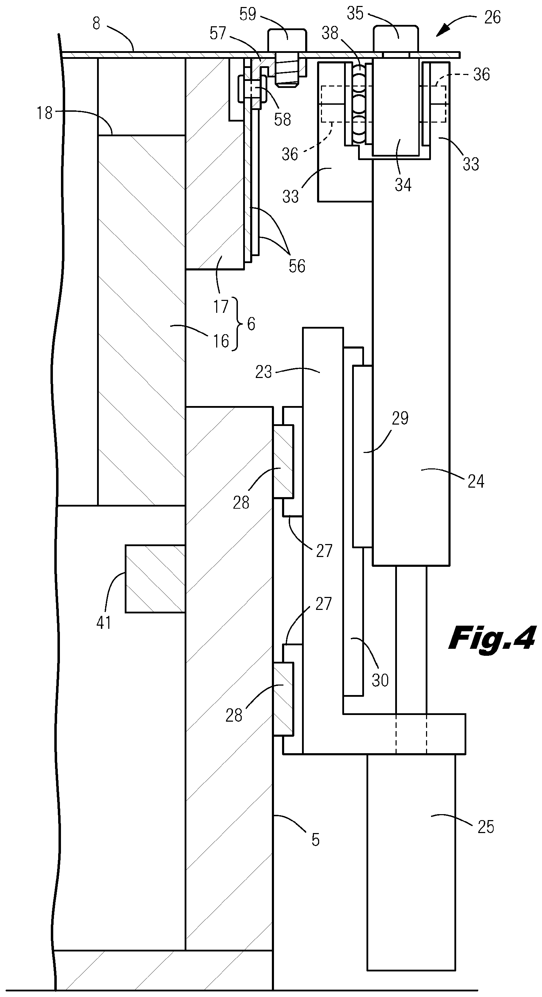

The stretching structure for stretching and holding the suction screen 8 includes a first stretching structure for stretching the suction screen 8 in a direction (front-rear direction) parallel to a bonding movement direction of the bonding roller 7, and a second stretching structure for stretching the suction screen 8 in a direction (left-right direction) orthogonal to the bonding movement direction of the bonding roller 7. In FIG. 3, the first stretching structure includes a fixed frame 20 that fixedly holds a front edge of the suction screen 8, a turning frame 21 that turns and guides the vicinity of a rear edge of the suction screen 8 downward, and a stretching cylinder 22 that pulls the rear edge of the suction screen 8 downward. As illustrated in FIG. 1, the second stretching structure is disposed on each of the left and right side parts of the base 5, and each second stretching structure includes, as illustrated in FIG. 4, five sets of slide stands 23 guided and supported by the base 5 so as to be able to slide back and forth, sliders 24 guided and supported by the slide stands 23 so as to be able to slide up and down, an elevating cylinder 25 that elevates and lowers the slider 24, and a connecting structure 26 that is mounted on an upper part of the slider 24 and fixedly holds the end part of the suction screen 8.

Each of the slide stands 23 is formed in an L shape, and a pair of upper and lower slide blocks 27 fixed to an inner surface of the vertical frame part is slidably guided and supported by a guide rail 28 in a front-rear direction fixed to the base 5. Further, in the vertically columnar slider 24, a vertically long slider 29 fixed to a lower inner surface thereof is slidably guided and supported by a guide rail 30 in a vertical direction fixed to an outer surface of the slide stand 23. The elevating cylinder 25 is fixed to a lower surface of a lateral frame part of the slide stand 23, and a piston rod thereof is connected to a lower end of the slider 24.

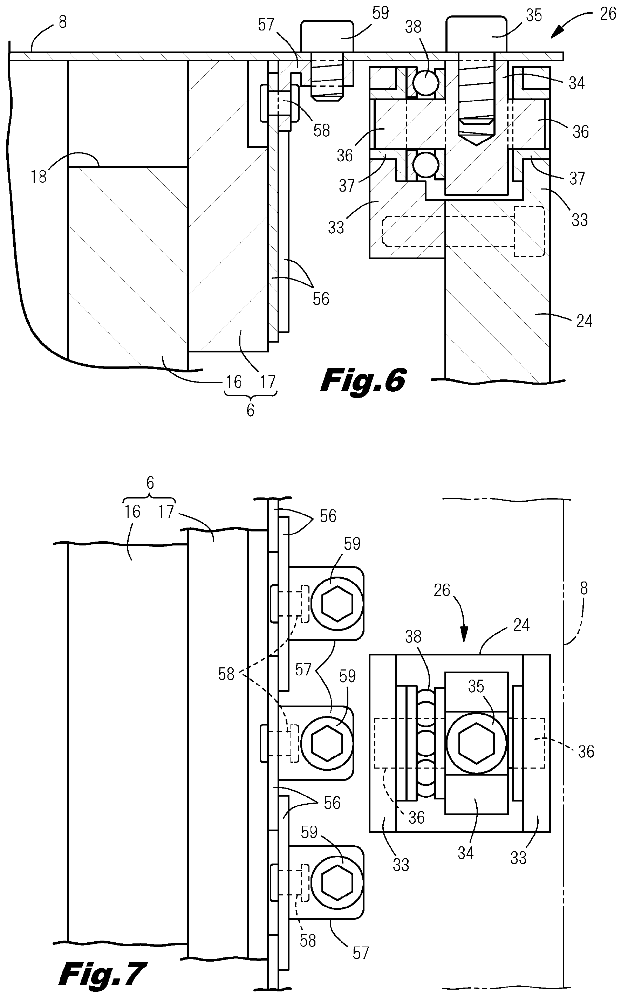

As illustrated in FIGS. 6 and 7, the connecting structure 26 includes a tilting block 34 tiltably supported by a pair of bearing parts 33 on an upper part of the slider 24, and a fastener 35 that cooperates with the tilting block 34 to sandwich and fix a side edge of the suction screen 8. As illustrated in FIG. 6, a tilting shaft 36 is integrally provided in the tilting block 34, and a shaft end of each tilting shaft 36 is tiltably supported by a bush 37 mounted on the bearing part 33. Further, a thrust bearing 38 that receives a stretching force of the suction screen 8 acting on the tilting block 34 is disposed between the bearing part 33 on an inner side surface side and the tilting block 34. The fastener 35 is formed of a hexagon socket head bolt, and a screw shaft thereof is screwed into the tilting block 34 to fasten and fix a side edge of the suction screen 8.

In FIG. 3, the roller moving structure includes a reverse gate type roller base 42 moved and guided by a guide rail 41 that is long in the front-rear direction and fixed to the base 5, a drive screw shaft 43 that is disposed in parallel with the guide rail 41 and is rotatably supported by a front-rear wall of the base 5, a motor 44 that drives the drive screw shaft 43 in forward and reverse directions, and a female screw body 45 that is mounted on the roller base 42 and meshes with the drive screw shaft 43. By rotationally driving the drive screw shaft 43 with the motor 44, the roller base 42 and the bonding roller 7 can be moved between the bonding start end (front end position illustrated in FIG. 3) and the bonding stop end (rear end position).

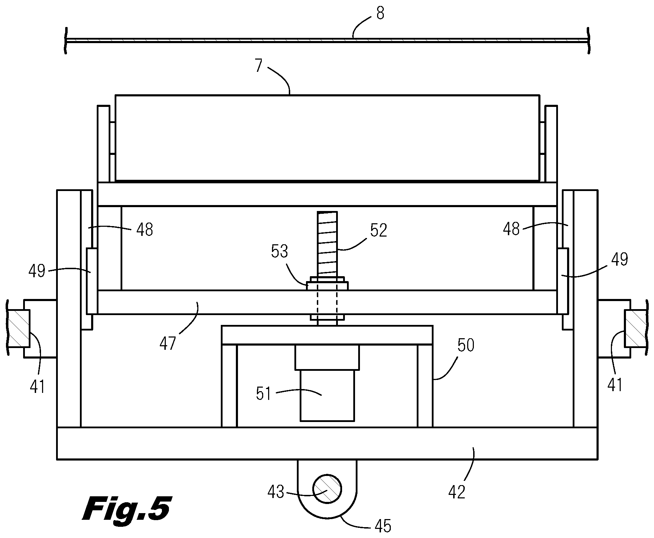

In FIG. 5, the bonding roller 7 is rotatably supported by an H-shaped roller base 47, and the roller elevating and lowering structure for elevating and lowering the bonding roller 7 according to the concavo-convex curved shape of the first workpiece W1 is provided between the roller base 47 and the previous roller base 42. The roller elevating and lowering structure includes a vertical guide rail 48 fixed to the left and right frames of the roller base 42, a slider 49 on a side of the roller base 47, which is slidably guided by the rail 48, an elevating and lowering table 50 fixed to a center of the roller base 42, a motor 51 fixed to the elevating and lowering table 50, an elevating and lowering screw shaft 52 driven forward and in reverse by the motor 51, a female screw body 53 mounted on the roller base 47 and meshing with the elevating and lowering screw shaft 52, and the like. When the elevating and lowering screw shaft 52 is rotationally driven by the motor 51, the roller base 47 and the bonding roller 7 are elevated and lowered along the concavo-convex curved shape of the first workpiece W1, and the second workpiece W2 can be bonded to the first workpiece W1.

A shielding structure for preventing outside air from entering the inside of the fixed suction base 16 is provided on an outer surface of the side part of the movable suction base 17. This shielding structure is constituted by a group of shielding plates 56 arranged on the outer surface of the side part of the movable suction base 17 facing the concavo-convex curved part 18, and in the present example, a plurality of shielding plates 56 are arranged along the outer surface of the movable suction base 17. As illustrated in FIGS. 4, 6, and 7, each of the shielding plates 56 is swingably suspended by a bracket 57 fixed to the suction screen 8 via a support shaft 58, and the bracket 57 is fastened and fixed to the suction screen 8 by a bolt 59. Adjacent ends of the shielding plates 56 adjacent in the front-rear direction alternately overlap with the inside, the outside, the inside, and the outside. As illustrated in FIG. 11, in a state where the upper opening surface of the movable suction base 17 is lowered to the workpiece transfer position below the concavo-convex curved part 18, a gap between the upper opening surface of the movable suction base 17 and the suction screen 8 is closed by the group of shielding plates 56. Therefore, in a state where the movable suction base 17 is lowered to the workpiece transfer position, the group of shielding plates 56 prevent the outside air from entering the inside of the lower suction base 6 through the gap, and the second workpiece W2 can be appropriately sucked and held following the concavo-convex shape of the concavo-convex curved part 18. The bracket 57 tilts as the suction screen 8 is deformed along the concavo-convex curved part 18. However, since the shielding plate 56 is swingably suspended by the support shaft 58, the shielding plate swings around the support shaft 58 as illustrated in FIG. 12 and is always suspended vertically.

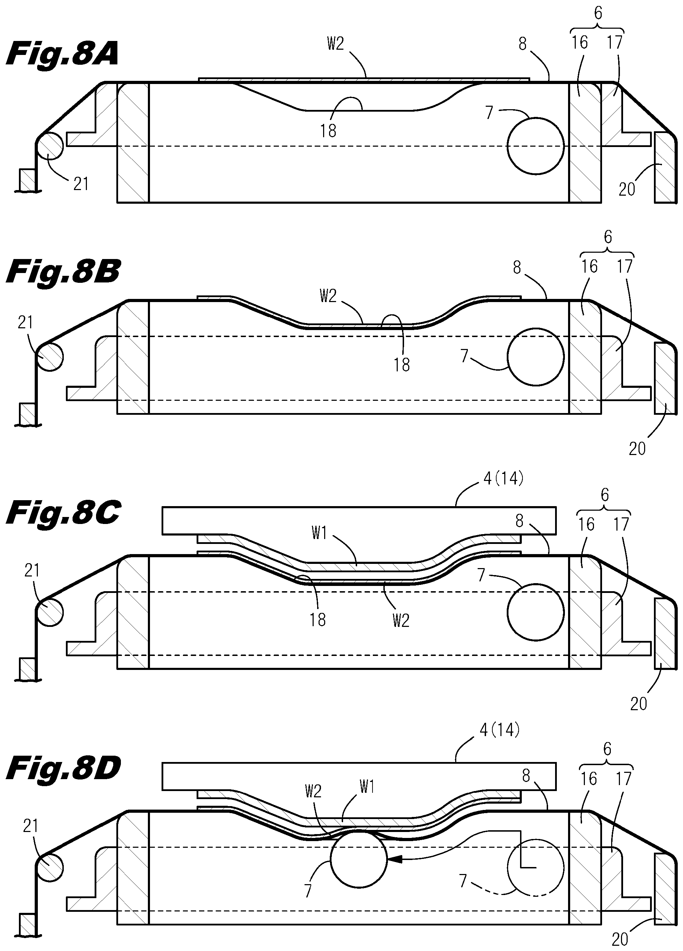

When the pair of workpieces W1 and W2 are bonded, the upper suction board 1 is held at the open position illustrated in FIGS. 1 and 2, and the first workpiece W1 is placed, and sucked and held on the suction base 14 of the upper suction base 4. Further, the second workpiece W2 is placed and positioned on the suction screen 8 in a state where the movable suction base 17 is held at the workpiece supporting position, and as illustrated in FIG. 8A, a vacuum pressure is applied to the inside of the lower suction base 6 to suck and hold the second workpiece W2 in a flat posture. At this time, since the left and right side edges of the suction screen 8 are supported by the side frame parts of the fixed suction base 16 and the movable suction base 17, the second workpiece W2 is held in a flat posture.

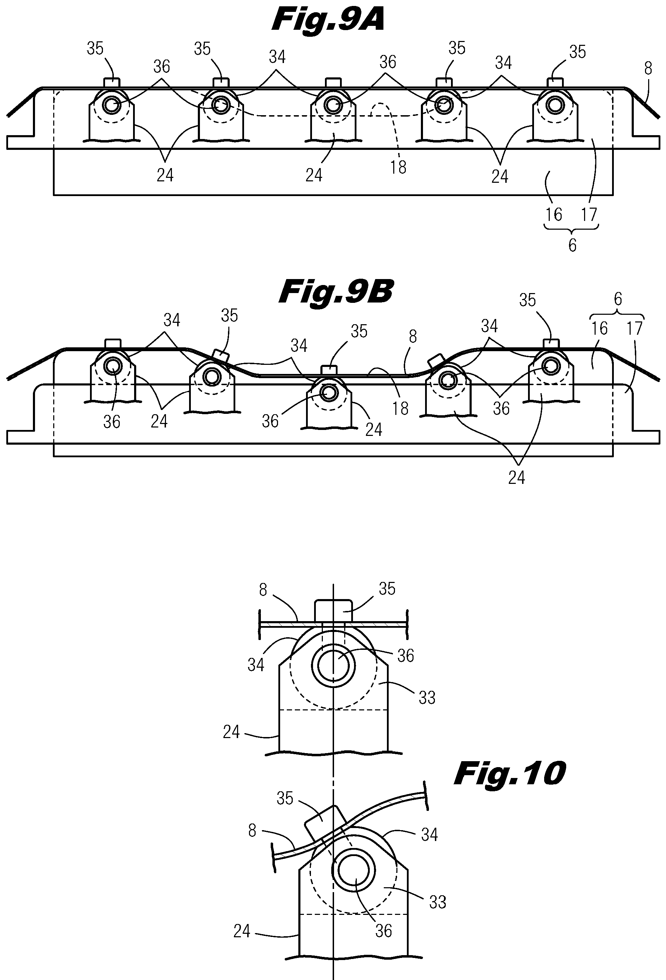

Next, when the movable suction base 17 is moved downward to the workpiece transfer position, since the left and right side edges of the suction screen 8 are supported only by the side frame parts of the fixed suction base 16, the suction screen 8 is deformed along the concavo-convex curved part 18 by the first and second stretching structures as illustrated in FIG. 8B, and is held in the same curved shape as the concavo-convex shape of the first workpiece W1. Accordingly, the second workpiece W2 is also held in the same curved shape as the concavo-convex shape of the first workpiece W1. At this time, the stretching force of the suction screen 8 acts on the tilting block 34, but the tilting block 34 tilts in conjunction with a deformation operation of the suction screen 8 as illustrated in FIG. 10. Further, the slider 24 and the slide stand 23 slide and move in a direction opposite to the tilting direction of the tilting block 34. This can prevent abnormal tension from acting on the suction screen 8. In this state, the upper suction board 1 is swung and moved to the bonding position as illustrated in FIG. 8C, and the upper suction base 4 and the lower suction base 6 face each other vertically, so that a facing interval between the first workpiece W1 and the second workpiece W2 is kept constant along the concavo-convex curved shape.

As described above, although the pair of workpieces W1 and W2 facing each other in the vertical direction are roughly positioned, the positional accuracy of both workpieces is not sufficient. In order to improve the positional accuracy to a precise level, shift detectors (CCD cameras) are disposed at two places of the upper suction board 1 to optically detect a positional shift of both the workpieces W1 and W2, an alignment controller recognizes the positional shift based on a result of the detection, and the alignment table 3 is operated based on a signal output from the controller to precisely position both the workpieces W1 and W2. That is, with the second workpiece W2 as a position reference, the upper suction base 4 and the first workpiece W1 are positionally corrected by the alignment table 3, and both the workpieces W1 and W2 are precisely positioned.

In a state where the pair of workpieces W1 and W2 is precisely positioned, as illustrated in FIG. 8D, the bonding roller 7 positioned at the bonding start end position is elevated from the standby position to the pressing position by the roller elevating and lowering structure, and in a state where the second workpiece W2 is pressed against the first workpiece W1, the roller 7 is moved from the bonding start end toward the bonding stop end, so that the second workpiece W2 is bonded to the first workpiece W1. When the bonding roller 7 moves toward the bonding stop end, the bonding roller 7 is elevated and lowered along the concavo-convex curved shape by the roller elevating and lowering structure, so that the second workpiece W2 can be bonded to the first workpiece W1 with a uniform pressing force. When the movement of the bonding roller 7 to the bonding stop end position is completed, the vacuum pressure acting on the lower suction base 6 is stopped, and the bonding roller 7 is returned to a bonding start end side in a state of being lowered to the standby position. Further, the upper suction board 1 is returned to the open position, and the vacuum pressure acting on the upper suction base 4 is stopped to take out a bonded body including the first workpiece W1 and the second workpiece W2. Thereafter, by repeatedly performing the above operation, it is possible to efficiently mass-produce the bonded body including the concavo-convex curved surface in which the protruding curved surface and the concave curved surface are continuous.

As described above, in the bonding device according to the present example, the second workpiece W2 is sucked and held in a flat posture on the suction screen 8 at the workpiece supporting position, and the second workpiece W2 is sucked and held in the concavo-convex curved shape via the suction screen 8 deformed exactly along the concavo-convex curved part 18 at the workpiece transfer position. Therefore, the second workpiece W2 can be deformed from the flat posture to the concavo-convex curved shape while the sucked and held state via the suction screen 8 is maintained in synchronization with the deformation of the suction screen 8 from the workpiece supporting position to the workpiece transfer position. As a result, it is possible to prevent a positional deviation from occurring between the suction screen 8 and the second workpiece W2, so that the workpieces W1 and W2 can be accurately bonded while being precisely positioned although the bonding surface of each of the workpieces W1 and W2 is formed to include a concavo-convex curved surface. Further, in the state where the workpieces W1 and W2 are bonded by the bonding roller 7, the bonding roller 7 is moved from the bonding start end to the bonding stop end while being moved up and down along the concavo-convex curved shape of the first workpiece W1, so that the workpieces W1 and W2 can be appropriately bonded according to the concavo-convex curved shape with an equal bonding force.

The stretching structure for stretching and holding the suction screen 8 includes the first stretching structure for stretching the suction screen 8 in a direction parallel to the bonding movement direction of the bonding roller 7, and the second stretching structure for stretching the suction screen 8 in a direction orthogonal to the bonding movement direction of the bonding roller 7. The second stretching structure includes a slide stand 23 that slides back and forth, a slider 24 that slides up and down with respect to the slide stand 23, an elevating cylinder 25 that elevates and lowers the slider 24, and a connecting structure 26 that fixedly holds an end part of the suction screen 8. The connecting structure 26 includes a tilting block 34 tiltably supported by the slider 24, and a fastener 35 that cooperates with the tilting block 34 to sandwich and fix the suction screen 8. Then, the suction screen 8 is deformed into a concavo-convex curved shape following the concavo-convex curved shape of the concavo-convex curved part 18, and the second workpiece W2 sucked and held by the suction screen 8 is deformed into the concavo-convex curved shape of the concavo-convex curved part 18 along with the deformation of the suction screen 8. In addition, the tilting block 34 facing the concavo-convex curved part 18 tilts along with the deformation of the suction screen 8, and the slide stand 23 slides in the front-rear direction. According to this, since the tilting block 34 can be tilted and the slide stand 23 can be slid while being dependent on the deformation of the suction screen 8, the suction screen 8 can be deformed into the concavo-convex curved shape while applying an appropriate stretching force to the suction screen 8. In other words, it is possible to deform the suction screen 8 into the concavo-convex curved shape while applying an appropriate stretching force to the suction screen 8 such that wrinkles and slack do not occur and excessive stress is not applied.

Since the tilting shaft 36 of the tilting block 34 is tiltably and pivotally supported by the bearing part 33 in the upper part of the slider 24, and the thrust bearing 38 that receives the stretching force of the suction screen 8 is disposed between the bearing part 33 and the tilting block 34, the stretching force of the suction screen 8 acting on the tilting block 34 can be received and released by the thrust bearing 38. Therefore, it is possible to suppress application of excessive stress to the suction screen 8 and to apply an appropriate stretching force to the suction screen 8.

Since the roller moving structure for moving the bonding roller 7 between the bonding start end and the bonding stop end is provided inside the fixed suction base 16, a roller moving speed when the bonding roller 7 moves up and down along the concavo-convex curved shape of the first workpiece W1 can be optimized only by controlling a driving rotation speed of the motor 44. Therefore, the second workpiece W2 can be uniformly and appropriately bonded to the first workpiece W1.

The roller elevating and lowering structure for elevating and lowering the bonding roller 7 according to the concavo-convex curved shape of the first workpiece W1 is provided between the roller base 47 supporting the bonding roller 7 and the roller base 42, and the roller elevating and lowering structure includes the roller base 47 slidably guided by the vertical guide rail 48 of the roller base 42, the elevating and lowering table 50 fixed to the roller base 42, the motor 51 fixed to the elevating and lowering table 50, the elevating and lowering screw shaft 52 driven forward and in reverse by the motor 51, and the female screw body 53 mounted on the roller base 47. Therefore, the elevating and lowering operation of the bonding roller 7 can be accurately performed along the concavo-convex curved shape of the first workpiece W1 by the roller elevating and lowering structure, and the second workpiece W2 can be constantly pressed against the first workpiece W1 with an even force, and the bonding of both workpieces W1 and W2 can always be appropriately performed.

The group of shielding plates 56 for preventing entry of outside air are arranged along an outer surface of the movable suction base 17 facing the concavo-convex curved part 18, and each of the shielding plates 56 is swingably suspended by the bracket 57 mounted on the suction screen 8 via the support shaft 58. Therefore, in a state where the movable suction base 17 is lowered to the workpiece transfer position, a gap between the upper opening surface of the movable suction base 17 facing the concavo-convex curved part 18 and the suction screen 8 can be closed by the shielding plate 56. Therefore, in the state where the movable suction base 17 is lowered to the workpiece transfer position, the group of shielding plates 56 prevent the outside air from entering the inside of the lower suction base 6, and the second workpiece W2 can be appropriately and continuously sucked and held along the concavo-convex shape of the concavo-convex curved part 18.

Since the adjacent ends of the adjacent shielding plates 56 overlap each other inside and outside, in a state where the movable suction base 17 is lowered to the workpiece transfer position, the group of shielding plates 56 are suspended in a vertical posture by the support shaft 58, and a gap between the upper opening surface of the movable suction base 17 and the suction screen 8 can be closed in a state where the adjacent ends of the shielding plates 56 overlap each other inside and outside. Further, since the shielding plates 56 are disposed in a state where the adjacent ends thereof overlap each other inside and outside, the space occupied by the shielding plates 56 can be made small and compact.

In addition, the bonding method according to the present example includes the steps of: sucking and holding the first workpiece W1 molded into a concavo-convex curved shape with the upper suction base 4, and placing and sucking and holding the second workpiece W2 on the suction screen 8 supported by the movable suction base 17 located at the workpiece supporting position; moving the movable suction base 17 to the workpiece transfer position, and sucking and holding the suction screen 8 and the second workpiece W2 along the concavo-convex curved shape of the concavo-convex curved part 18 of the fixed suction base 16; causing the upper suction base 4 and the lower suction base 6 to vertically face each other to match the concavo-convex curved shapes of the first workpiece W1 and the second workpiece W2, and keeping a facing interval between the first workpiece W1 and the second workpiece W2 constant; and bonding the second workpiece W2 to the first workpiece W1 by elevating the bonding roller 7 provided inside the fixed suction base 16 by the roller elevating and lowering structure to press the second workpiece W2 against the first workpiece W1, and moving the bonding roller 7 toward the bonding stop end by the roller moving structure in this state. Further, in the step of bonding the second workpiece W2 to the first workpiece W1, the bonding roller 7 is moved up and down along the concavo-convex curved shape of the first workpiece W1 by the roller elevating and lowering structure, and the second workpiece W2 is bonded to the first workpiece W1 with a uniform pressing force.

According to the bonding method described above, the concavo-convex curved part 18 of the fixed suction base 16 can suck and hold the second workpiece W2, which is flat in a normal state, exactly along the concavo-convex curved shape of the first workpiece W1, so that the workpieces W1 and W2 can be precisely positioned and bonded with high accuracy even though the bonding surfaces of the workpieces W1 and W2 are formed of the concavo-convex curved surfaces.

In the above embodiment, the upper opening surface of the movable suction base 17 at the workpiece supporting position is flush with the upper opening surface of the fixed suction base 16, but this is not necessary, and the upper opening surface of the movable suction base 17 at the workpiece supporting position may be located above the upper opening surface of the fixed suction base 16. In addition, the tilting shaft 36 may be formed separately from the tilting block 34.

The bonded body obtained by bonding the pair of workpieces W1 and W2 is used, for example, as an instrument panel for integrating and displaying an instrument or a display of an automobile.

### REFERENCE SIGNS LIST

- 1: upper suction board
- 2: lower suction plate
- 4: upper suction base
- 5: base
- 6: lower suction base
- 7: bonding roller
- 8: suction screen
- 14: suction base
- 16: fixed suction base
- 17: movable suction base
- 18: concavo-convex curved part
- 23: slide stand
- 24: slider
- 25: elevating cylinder
- 26: connecting structure
- 33: bearing part
- 34: tilting block
- 35: fastening tool
- 36: tilting shaft
- 38: thrust bearing
- 41: guide rail
- 42: roller base
- 43: drive screw shaft
- 44: motor
- 45: female screw body
- 47: roller base
- 50: elevating and lowering table
- 51: motor
- 52: elevating and lowering screw shaft
- 53: female screw body
- 56: shielding plate

## Claims

1. A bonding device comprising: an upper suction board (1) including an upper suction base (4) that sucks and holds a first workpiece (W1); and a lower suction board (2) including a lower suction base (6) that sucks and holds a second workpiece (W2), wherein
the upper suction base (4) is provided with a suction base (14) that sucks and holds the first workpiece (W1) molded, in advance, including a concavo-convex curved shape in which a protruding curved surface and a concave curved surface are continuous,
the lower suction base (6) is provided with a fixed suction base (16) having a frame structure fixed to a base (5), a movable suction base (17) having a frame structure disposed around the fixed suction base (16), and a suction screen (8) that covers an upper opening surface of the movable suction base (17),
the movable suction base (17) is configured to be vertically movable between: a workpiece supporting position where the upper opening surface of the movable suction base (17) is located above an upper opening surface of the fixed suction base (16) and the second workpiece (W2) on the suction screen (8) is sucked and held in a flat posture; and a workpiece transfer position where the upper opening surface is lowered below the upper opening surface of the fixed suction base (16) and the suction screen (8) is supported by the upper opening surface of the fixed suction base (16),
a concavo-convex curved part (18) corresponding to the concavo-convex curved shape of the first workpiece (W1) is formed in a peripheral frame part of the fixed suction base (16), and in a state where the movable suction base (17) is lowered to the workpiece transfer position, the second workpiece (W2) supported in a flat posture by the suction screen (8) is sucked and held in a concavo-convex curved shape via the suction screen (8) deformed exactly along the concavo-convex curved part (18), and
in a state where the first workpiece (W1) sucked and held by the upper suction base (4) and the second workpiece (W2) sucked and held by the lower suction base (6) face each other vertically, the second workpiece (W2) is pressed against the first workpiece (W1) by a bonding roller (7) provided inside the fixed suction base (16), and in this state, by moving the bonding roller (7) from a bonding start end to a bonding stop end while moving the bonding roller (7) up and down along the concavo-convex curved shape of the first workpiece (W1), the first workpiece (W1) and the second workpiece (W2) are bonded.

2. The bonding device according to claim 1, wherein
each of the fixed suction base (16) and the movable suction base (17) is formed in a square frame shape,
the concavo-convex curved part (18) is formed on each side part of one of facing side parts, out of four peripheral side parts constituting the fixed suction base (16), and a stretching structure that stretches and holds the suction screen (8) is disposed outside the facing side parts,
the stretching structure includes a first stretching structure that stretches the suction screen (8) in a direction parallel to a bonding movement direction of the bonding roller (7), and a second stretching structure that stretches the suction screen (8) in a direction orthogonal to the bonding movement direction of the bonding roller (7),
the second stretching structure includes a slide stand (23) that is guided and supported by the base (5) so as to be able to slide back and forth, a slider (24) that is guided and supported by the slide stand (23) so as to be able to slide up and down, an elevating cylinder (25) that performs an elevating operation of the slider (24) to stretch the suction screen (8), and a connecting structure (26) that is mounted on the slider (24) and fixedly holds an end part of the suction screen (8),
the connecting structure (26) includes a tilting block (34) tiltably supported by the slider (24), and a fastener (35) that cooperates with the tilting block (34) to sandwich and fix the suction screen (8),
the suction screen (8) is deformed into a concavo-convex curved shape following the concavo-convex curved shape of the concavo-convex curved part (18), and the second workpiece (W2) sucked and held by the suction screen (8) is deformed into the concavo-convex curved shape of the concavo-convex curved part (18) along with the deformation of the suction screen (8), and
in addition, it is configured that the tilting block (34) facing the concavo-convex curved part (18) tilts and the slide stand (23) slides in a front-rear direction, along with the deformation of the suction screen (8).

3. The bonding device according to claim 2, wherein
a tilting shaft (36) of the tilting block (34) is tiltably and pivotally supported by a bearing part (33) provided in an upper part of the slider (24), and
a thrust bearing (38) that receives a stretching force of the suction screen (8) is disposed between the bearing part (33) and the tilting block (34).

4. The bonding device according to any one of claims 1 to 3, wherein
a roller moving structure that moves the bonding roller (7) between the bonding start end and the bonding stop end is provided inside the fixed suction base (16), and
the roller moving structure includes a roller base (42) that is movably guided by a guide rail (41) fixed to the base (5), a drive screw shaft (43) that is disposed in parallel with the guide rail (41) and rotatably supported by the base (5), a motor (44) that drives the drive screw shaft (43) forward and in reverse, and a female screw body (45) that is mounted on the roller base (42) and meshes with the drive screw shaft (43).

5. The bonding device according to claim 4, wherein
a roller elevating and lowering structure that elevates and lowers the bonding roller (7) following the concavo-convex curved shape of the first workpiece (W1) is provided between a roller base (47) that rotatably supports the bonding roller (7) and the roller base (42), and
the roller elevating and lowering structure includes a roller base (47) slidably guided by a vertical guide rail (48) of the roller base (42), an elevating and lowering table (50) fixed to the roller base (42), a motor (51) fixed to the elevating and lowering table (50), an elevating and lowering screw shaft (52) driven forward and in reverse by the motor (51), and a female screw body (53) that is mounted on the roller base (47) and meshes with the elevating and lowering screw shaft (52).

6. The bonding device according to any one of claims 1 to 5, wherein
along an outer surface of a side part of the movable suction base (17) facing the concavo-convex curved part (18), a group of shielding plates (56) that prevent outside air from entering an inside of the fixed suction base (16) are disposed,
each of the shielding plates (56) is swingably suspended by a bracket (57) mounted on the suction screen (8) via a support shaft (58), and
it is configured that a gap between the upper opening surface of the movable suction base (17) facing the concavo-convex curved part (18) and the suction screen (8) is closed by the shielding plates (56) in a state where the movable suction base (17) is lowered to the workpiece transfer position.

7. The bonding device according to claim 6, wherein
adjacent ends of the adjacent shielding plates (56) overlap each other inside and outside, and
in a state where the movable suction base (17) is lowered to the workpiece transfer position, the group of shielding plates (56) are suspended in a vertical posture by the support shaft (58), and the gap between the upper opening surface of the movable suction base (17) and the suction screen (8) is closed in a state where the adjacent ends of the shielding plates (56) overlap each other inside and outside.

8. A bonding method of a first workpiece (W1) sucked and held by an upper suction base (4) and a second workpiece (W2) sucked and held by a lower suction base (6), which is provided with a fixed suction base (16) having a frame structure fixed to a base (5), a movable suction base (17) having a frame structure disposed around the fixed suction base (16), and a suction screen (8) that covers an upper opening surface of the movable suction base (17), the bonding method comprising the steps of:
sucking and holding, with the upper suction base (4), the first workpiece (W1) molded in advance into a concavo-convex curved shape in which a protruding curved surface and a concave curved surface are continuous by the upper suction base (4), and placing the second workpiece (W2) on the suction screen (8) supported flat by the movable suction base (17) moved to a workpiece supporting position and sucking and holding the second workpiece (W2);
moving the movable suction base (17) downward to a workpiece transfer position to deform the suction screen (8) into a concavo-convex curved shape following a concavo-convex curved shape of a concavo-convex curved part (18) formed on the fixed suction base (16), and deforming the second workpiece (W2) sucked and held by the suction screen (8) into the concavo-convex curved shape of the concavo-convex curved part (18) accompanying the deformation of the suction screen (8);
causing the upper suction base (4) and the lower suction base (6) to vertically face each other to match the concavo-convex curved shapes of the first workpiece (W1) and the second workpiece (W2), and keeping a facing interval between the workpieces (W1 and W2) constant along the concavo-convex curved shapes; and
bonding the second workpiece (W2) to the first workpiece (W1) by moving a bonding roller (7) provided inside the fixed suction base (16) from a bonding start end toward a bonding stop end by a roller moving structure in a state where the second workpiece (W2) is pressed against the first workpiece (W1) by elevating the bonding roller (7) from a standby position to a pressing position by a roller elevating and lowering structure,
wherein, in the step of bonding the second workpiece (W2) to the first workpiece (W1), the bonding roller (7) is elevated and lowered along the concavo-convex curved shape of the first workpiece (W1) by the roller elevating and lowering structure to bond the second workpiece (W2) to the first workpiece (W1) with a uniform pressing force.

## Patentansprüche

1. Verbindungsvorrichtung umfassend: eine obere Saugplatte (1) einschließlich einer oberen Saugbasis (4), die ein erstes Werkstück (W1) ansaugt und hält; und eine untere Saugplatte (2) einschließlich einer unteren Saugbasis (6), die ein zweites Werkstück (W2) ansaugt und hält, wobei
die obere Saugbasis (4) mit einer Saugbasis (14) versehen ist, die das erste Werkstück (W1) ansaugt und hält, das im Voraus einschließlich einer konkav-konvexen gekrümmten Form geformt wurde, bei der eine vorstehende gekrümmte Oberfläche und eine konkave gekrümmte Oberfläche durchgehend sind,
die untere Ansaugbasis (6) mit einer festen Ansaugbasis (16), die eine an einer Basis (5) befestigte Rahmenstruktur aufweist, einer beweglichen Ansaugbasis (17), die eine um die feste Ansaugbasis (16) herum angeordnete Rahmenstruktur aufweist, und einem Ansaugschirm (8) versehen ist, der eine obere Öffnungsfläche der beweglichen Ansaugbasis (17) abdeckt,
die bewegliche Saugbasis (17) konfiguriert ist, um vertikal beweglich zu sein zwischen: einer Werkstückstützposition, in der die obere Öffnungsfläche der beweglichen Saugbasis (17) über einer oberen Öffnungsfläche der festen Saugbasis (16) angeordnet ist und das zweite Werkstück (W2) auf dem Saugschirm (8) angesaugt und in einer flachen Position gehalten wird; und einer Werkstücktransferposition, in der die obere Öffnungsfläche unter die obere Öffnungsfläche der festen Saugbasis (16) abgesenkt ist und der Saugschirm (8) von der oberen Öffnungsfläche der festen Saugbasis (16) getragen wird,
ein konkav-konvex gekrümmter Teil (18), der der konkav-konvex gekrümmten Form des ersten Werkstücks (W1) entspricht, in einem peripheren Rahmenteil der festen Saugbasis (16) ausgebildet ist, und in einem Zustand, in dem die bewegliche Saugbasis (17) in die Werkstücktransferposition abgesenkt ist, das zweite Werkstück (W2), das in einer flachen Haltung durch den Saugschirm (8) gehalten wird, angesaugt und in einer konkav-konvex gekrümmten Form über den Saugschirm (8) gehalten wird, der genau entlang des konkav-konvex gekrümmten Teils (18) verformt ist, und
in einem Zustand, in dem das erste Werkstück (W1), das von der oberen Saugbasis (4) angesaugt und gehalten wird, und das zweite Werkstück (W2), das von der unteren Saugbasis (6) angesaugt und gehalten wird, einander vertikal gegenüberliegen, das zweite Werkstück (W2) durch eine Verbindungswalze (7), die im Inneren der festen Saugbasis (16) vorgesehen ist, gegen das erste Werkstück (W1) gedrückt wird, und in diesem Zustand durch Bewegen der Verbindungswalze (7) von einem Verbindungsanfangsende zu einem Verbindungsstoppende, während die Verbindungswalze (7) entlang der konkav-konvex gekrümmten Form des ersten Werkstücks (W1) auf und ab bewegt wird, das erste Werkstück (W1) und das zweite Werkstück (W2) miteinander verbunden werden.

2. Verbindungsvorrichtung nach Anspruch 1, wobei
der feste Saugfuß (16) und der bewegliche Saugfuß (17) jeweils die Form eines quadratischen Rahmens haben,
der konkav-konvexe gekrümmte Teil (18) an jedem Seitenteil eines der gegenüberliegenden Seitenteile von vier Umfangsseitenteilen ausgebildet ist, die die feste Saugbasis (16) bilden, und eine Streckstruktur, die den Saugschirm (8) streckt und hält, außerhalb der gegenüberliegenden Seitenteile angeordnet ist,
die Streckstruktur eine erste Streckstruktur einschließt, die den Saugschirm (8) in einer Richtung parallel zu einer Verbindungsbewegungsrichtung der Verbindungswalze (7) streckt, und eine zweite Streckstruktur, die den Saugschirm (8) in einer Richtung orthogonal zu der Verbindungsbewegungsrichtung der Verbindungswalze (7) streckt,
die zweite Streckstruktur einen Gleitständer (23) einschließt, der von der Basis (5) so geführt und gestützt wird, dass er vor und zurück gleiten kann, einen Gleiter (24), der von dem Gleitständer (23) so geführt und gestützt wird, dass er auf und ab gleiten kann, einen Hebezylinder (25), der einen Hebevorgang des Gleiters (24) durchführt, um den Ansaugschirm (8) zu strecken, und eine Verbindungsstruktur (26) umfasst, die an dem Gleiter (24) angebracht ist und ein Endteil des Ansaugschirms (8) fest hält,
die Verbindungsstruktur (26) einen kippbaren Block (34), der kippbar von dem Gleiter (24) getragen wird, und ein Befestigungselement (35) umfasst, das mit dem kippbaren Block (34) zusammenwirkt, um den Saugschirm (8) einzuschließen und zu befestigen,
der Saugschirm (8) in eine konkav-konvex gekrümmte Form verformt wird, die der konkav-konvex gekrümmten Form des konkav-konvex gekrümmten Teils (18) folgt, und das zweite Werkstück (W2), das von dem Saugschirm (8) angesaugt und gehalten wird, in die konkav-konvex gekrümmte Form des konkav-konvex gekrümmten Teils (18) zusammen mit der Verformung des Saugschirms (8) verformt wird, und
darüber hinaus so konfiguriert ist, dass der Kippblock (34), der dem konkav-konvex gekrümmten Teil (18) zugewandt ist, kippt und der Gleitständer (23) in einer Richtung von vorne nach hinten gleitet, zusammen mit der Verformung des Saugschirms (8).

3. Verbindungsvorrichtung nach Anspruch 2, wobei
eine Kippwelle (36) des Kippblocks (34) kippbar und schwenkbar von einem Lagerteil (33) getragen wird, das in einem oberen Teil des Gleiters (24) vorgesehen ist, und
ein Axiallager (38), das eine Spannkraft des Saugschirms (8) aufnimmt, zwischen dem Lagerteil (33) und dem Kippblock (34) angeordnet ist.

4. Verbindungsvorrichtung nach einem der Ansprüche 1 bis 3, wobei
eine Rollenbewegungsstruktur, die die Verbindungswalze (7) zwischen dem Verbindungsanfangsende und dem Verbindungsstoppende bewegt, innerhalb der festen Saugbasis (16) vorgesehen ist, und
die Rollenbewegungsstruktur eine Rollenbasis (42), die durch eine an der Basis (5) befestigte Führungsschiene (41) beweglich geführt wird, eine Antriebsschraubenwelle (43), die parallel zur Führungsschiene (41) angeordnet ist und drehbar von der Basis (5) getragen wird, einen Motor (44), der die Antriebsschraubenwelle (43) vorwärts und rückwärts antreibt, und einen weiblichen Schraubenkörper (45) umfasst, der an der Rollenbasis (42) angebracht ist und mit der Antriebsschraubenwelle (43) in Eingriff steht.

5. Verbindungsvorrichtung nach Anspruch 4, wobei
eine Rollenhebe- und -senkstruktur, die die Verbindungswalze (7) entsprechend der konkav-konvex gekrümmten Form des ersten Werkstücks (W1) anhebt und absenkt, zwischen einer Rollenbasis (47), die die Verbindungswalze (7) drehbar trägt, und der Rollenbasis (42) vorgesehen ist, und
die Rollenhebe- und -senkstruktur eine Rollenbasis (47), die durch eine vertikale Führungsschiene (48) der Rollenbasis (42) gleitend geführt wird, einen an der Rollenbasis (42) befestigten Hebe- und Senktisch (50), einen an dem Hebe- und Senktisch (50) befestigten Motor (51), eine durch den Motor (51) vorwärts und rückwärts angetriebene Hebe- und Senkschneckenwelle (52) und einen weiblichen Schneckenkörper (53) umfasst, der an der Rollenbasis (47) angebracht ist und mit der Hebe- und Senkschneckenwelle (52) in Eingriff steht.

6. Verbindungsvorrichtung nach einem der Ansprüche 1 bis 5, wobei
entlang einer Außenfläche eines Seitenteils der beweglichen Saugbasis (17), die dem konkav-konvex gekrümmten Teil (18) zugewandt ist, eine Gruppe von Abschirmplatten (56) angeordnet ist, die verhindern, dass Außenluft in das Innere der festen Saugbasis (16) eindringt,
jedes der Abschirmbleche (56) über eine Tragwelle (58) schwenkbar an einem am Saugschirm (8) angebrachten Bügel (57) aufgehängt ist, und
es so konfiguriert ist, dass ein Spalt zwischen der oberen Öffnungsfläche der beweglichen Saugbasis (17), die dem konkav-konvex gekrümmten Teil (18) zugewandt ist, und dem Saugschirm (8) durch die Abschirmplatten (56) in einem Zustand geschlossen ist, in dem die bewegliche Saugbasis (17) in die Werkstückübergabeposition abgesenkt ist.

7. Verbindungsvorrichtung nach Anspruch 6, wobei
benachbarte Enden der benachbarten Abschirmbleche (56) sich innen und außen überlappen, und
in einem Zustand, in dem die bewegliche Saugbasis (17) in die Werkstückübergabeposition abgesenkt ist, die Gruppe von Abschirmplatten (56) in einer vertikalen Position durch die Stützwelle (58) aufgehängt ist, und der Spalt zwischen der oberen Öffnungsfläche der beweglichen Saugbasis (17) und dem Saugschirm (8) in einem Zustand geschlossen ist, in dem die benachbarten Enden der Abschirmplatten (56) einander innen und außen überlappen.

8. Verbindungsverfahren eines ersten Werkstücks (W1), das von einer oberen Saugbasis (4) angesaugt und gehalten wird, und eines zweiten Werkstücks (W2), das von einer unteren Saugbasis (6) angesaugt und gehalten wird, die mit einer festen Saugbasis (16), die eine an einer Basis (5) befestigte Rahmenstruktur aufweist, einer beweglichen Saugbasis (17), die eine um die feste Saugbasis (16) herum angeordnete Rahmenstruktur aufweist, und einem Saugschirm (8), der eine obere Öffnungsfläche der beweglichen Saugbasis (17) abdeckt, versehen ist, das Verbindungsverfahren die folgenden Schritte umfassend:
Saugen und Halten des ersten Werkstücks (W1), das im Voraus zu einer konkav-konvex gekrümmten Form geformt wurde, bei der eine vorstehende gekrümmte Oberfläche und eine konkav gekrümmte Oberfläche durch die obere Saugbasis (4) fortlaufend sind, mit der oberen Saugbasis (4), und Platzieren des zweiten Werkstücks (W2) auf dem Saugschirm (8), der durch die bewegliche Saugbasis (17), die in eine Werkstückstützposition bewegt wird, flach gehalten wird, und Saugen und Halten des zweiten Werkstücks (W2);
Bewegen der beweglichen Saugbasis (17) nach unten in eine Werkstücktransferposition, um den Saugschirm (8) in eine konkav-konvexe gekrümmte Form zu verformen, die einer konkav-konvexen gekrümmten Form eines konkav-konvexen gekrümmten Teils (18) folgt, das auf der festen Saugbasis (16) ausgebildet ist, und Verformen des zweiten Werkstücks (W2), das von dem Saugschirm (8) angesaugt und gehalten wird, in die konkav-konvex gekrümmte Form des konkav-konvex gekrümmten Teils (18), die die Verformung des Saugschirms (8) begleitet;
Bewirken, dass die obere Saugbasis (4) und die untere Saugbasis (6) vertikal einander zugewandt sind, um mit den konkav-konvex gekrümmten Formen des ersten Werkstücks (W1) und des zweiten Werkstücks (W2) übereinzustimmen, und Halten eines einander zugewandten Abstands zwischen den Werkstücken (W1 und W2) entlang der konkav-konvex gekrümmten Formen; und
Verbinden des zweiten Werkstücks (W2) mit dem ersten Werkstück (W1) durch Bewegen einer Verbindungswalze (7), die innerhalb der festen Saugbasis (16) vorgesehen ist, von einem Verbindungsstartende zu einem Verbindungsstoppende durch eine Walzenbewegungsstruktur in einem Zustand, in dem das zweite Werkstück (W2) gegen das erste Werkstück (W1) gepresst wird, durch Anheben der Verbindungswalze (7) von einer Bereitschaftsposition zu einer Pressposition durch eine Walzenhebe- und - absenkstruktur,
wobei in dem Schritt des Verbindens des zweiten Werkstücks (W2) mit dem ersten Werkstück (W1) die Verbindungswalze (7) entlang der konkav-konvex gekrümmten Form des ersten Werkstücks (W1) durch die Walzenhebe- und -absenkstruktur angehoben und abgesenkt wird, um das zweite Werkstück (W2) mit einer gleichmäßigen Druckkraft mit dem ersten Werkstück (W1) zu verbinden.

## Revendications

1. Dispositif de collage comprenant : une plaque d'aspiration supérieure (1) incluant une base d'aspiration supérieure (4) qui aspire et maintient une première pièce à travailler (W1) ; et une plaque d'aspiration inférieure (2) incluant une base d'aspiration inférieure (6) qui aspire et maintient une seconde pièce à travailler (W2), dans lequel
la base d'aspiration supérieure (4) est dotée d'une base d'aspiration (14) qui aspire et maintient la première pièce à travailler (W1) préalablement moulée, comprenant une forme courbe concavo-convexe dans laquelle une surface incurvée saillante et une surface incurvée concave sont continues,
la base d'aspiration inférieure (6) est dotée d'une base d'aspiration fixe (16) comportant une structure de cadre fixée à une base (5), d'une base d'aspiration mobile (17) comportant une structure de cadre disposée autour de la base d'aspiration fixe (16), et d'un tamis d'aspiration (8) qui couvre une surface d'ouverture supérieure de la base d'aspiration mobile (17),
la base d'aspiration mobile (17) est configurée pour être déplaçable verticalement entre : une position de soutien de pièce à travailler où la surface d'ouverture supérieure de la base d'aspiration mobile (17) est située au-dessus d'une surface d'ouverture supérieure de la base d'aspiration fixe (16) et la seconde pièce à travailler (W2) sur le tamis d'aspiration (8) est aspirée et maintenue dans une position à plat ; et une position de transfert de pièces à travailler où la surface d'ouverture supérieure est abaissée au-dessous de la surface d'ouverture supérieure de la base d'aspiration fixe (16) et le tamis d'aspiration (8) est soutenu par la surface d'ouverture supérieure de la base d'aspiration fixe (16),
une partie incurvée concavo-convexe (18) correspondant à la forme courbe concavo-convexe de la première pièce à travailler (W1) est formée dans une partie de cadre périphérique de la base d'aspiration fixe (16), et dans un état où la base d'aspiration mobile (17) est abaissée jusqu'à la position de transfert de pièces à travailler, la seconde pièce à travailler (W2) soutenue dans une position à plat par le tamis d'aspiration (8) est aspirée et maintenue en une forme courbe concavo-convexe via le tamis d'aspiration (8) déformé exactement le long de la partie incurvée concavo-convexe (18), et
dans un état où la première pièce à travailler (W1) aspirée et maintenue par la base d'aspiration supérieure (4) et la seconde pièce à travailler (W2) aspirée et maintenue par la base d'aspiration inférieure (6) se font face verticalement, la seconde pièce à travailler (W2) est pressée contre la première pièce à travailler (W1) par un rouleau de collage (7) disposé à l'intérieur de la base d'aspiration fixe (16), et dans cet état, par déplacement du rouleau de collage (7) depuis une extrémité de début de collage jusqu'à une extrémité de fin de collage tout en déplaçant le rouleau de collage (7) de haut en bas le long de la forme courbe concavo-convexe de la première pièce à travailler (W1), la première pièce à travailler (W1) et la seconde pièce à travailler (W2) sont collées.

2. Dispositif de collage selon la revendication 1, dans lequel
chacune parmi la base d'aspiration fixe (16) et la base d'aspiration mobile (17) est façonnée en une forme de cadre carré,
la partie incurvée concavo-convexe (18) est formée sur chaque partie latérale d'une de parties latérales se faisant face, parmi quatre parties latérales périphériques constituant la base d'aspiration fixe (16), et une structure d'étirage qui étire et maintient le tamis d'aspiration (8) est disposée à l'extérieur des parties latérales se faisant face,
la structure d'étirage comprend une première structure d'étirage qui étire le tamis d'aspiration (8) dans une direction parallèle à une direction de mouvement de collage du rouleau de collage (7), et une seconde structure d'étirage qui étire le tamis d'aspiration (8) dans une direction orthogonale à la direction de mouvement de collage du rouleau de collage (7),
la seconde structure d'étirage comprend un support coulissant (23) qui est guidé et soutenu par la base (5) de manière à pouvoir coulisser d'avant en arrière, un coulisseau (24) qui est guidé et soutenu par le support coulissant (23) de manière à pouvoir coulisser de haut en bas, un cylindre d'élévation (25) qui effectue une opération d'élévation du coulisseau (24) pour étirer le tamis d'aspiration (8), et une structure de liaison (26) qui est montée sur le coulisseau (24) et maintient fixement une partie d'extrémité du tamis d'aspiration (8),
la structure de liaison (26) comprend un bloc basculant (34) soutenu de manière basculante par le coulisseau (24), et un élément de fixation (35) qui coopère avec le bloc basculant (34) pour maintenir entre eux le tamis d'aspiration (8) et le fixer,
le tamis d'aspiration (8) est déformé en une forme courbe concavo-convexe suivant la forme courbe concavo-convexe de la partie incurvée concavo-convexe (18), et la seconde pièce à travailler (W2), aspirée et maintenue par le tamis d'aspiration (8), est déformée en la forme courbe concavo-convexe de la partie incurvée concavo-convexe (18) conformément à la déformation du tamis d'aspiration (8), et
en outre, il est configuré que le bloc basculant (34) faisant face à la partie incurvée concavo-convexe (18) bascule et que le support coulissant (23) coulisse dans une direction avant-arrière, conformément à déformation du tamis d'aspiration (8).

3. Dispositif de collage selon la revendication 2, dans lequel
un axe de basculement (36) du bloc basculant (34) est soutenu de manière à basculer et pivoter par une pièce d'appui (33) disposée dans une partie supérieure du coulisseau (24), et
un palier de butée (38) qui reçoit une force d'étirage du tamis d'aspiration (8) est disposé entre la pièce de palier (33) et le bloc basculant (34).

4. Dispositif de collage selon l'une quelconque des revendications 1 à 3, dans lequel
une structure de déplacement de rouleau qui déplace le rouleau de collage (7) entre l'extrémité de début de collage et l'extrémité de fin de collage est disposée à l'intérieur de la base d'aspiration fixe (16), et
la structure de déplacement de rouleau comprend une base (42) pour rouleau qui est guidée de manière mobile par un rail de guidage (41) fixé à la base (5), un arbre (43) à vis d'entraînement qui est disposé parallèlement au rail de guidage (41) et soutenu de manière rotative par la base (5), un moteur (44) qui entraîne l'arbre (43) à vis d'entraînement en avant et en arrière, et un corps de vis femelle (45) qui est monté sur la base (42) pour rouleau et s'engrène avec l'arbre (43) à vis d'entraînement.

5. Dispositif de collage selon la revendication 4, dans lequel
une structure d'élévation et d'abaissement de rouleau qui élève et abaisse le rouleau de collage (7) en suivant la forme courbe concavo-convexe de la première pièce à travailler (W1) est disposée entre une base (47) pour rouleau, qui soutient de manière rotative le rouleau de collage (7) et la base (42) pour rouleau, et
la structure d'élévation et d'abaissement de rouleau comprend une base (47) pour rouleau guidée de manière coulissante par un rail de guidage vertical (48) de la base (42) pour rouleau, une table d'élévation et d'abaissement (50) fixée à la base (42) pour rouleau , un moteur (51) fixé à la table d'élévation et d'abaissement (50), un axe (52) à vis d'élévation et d'abaissement, entraîné en avant et en arrière par le moteur (51), et un corps de vis femelle (53) qui est monté sur la base (47) pour rouleau et s'engrène avec l'arbre (52) à vis d'élévation et d'abaissement .

6. Dispositif de collage selon l'une quelconque des revendications 1 à 5, dans lequel
le long d'une surface externe d'une partie latérale de la base d'aspiration mobile (17) faisant face à la partie incurvée concavo-convexe (18) est disposé un groupe de plaques de protection (56) qui empêchent la pénétration d'air extérieur à l'intérieur de la base d'aspiration fixe (16),
chacune des plaques de protection (56) est suspendue de manière oscillante par un élément de fixation (57) monté sur le tamis d'aspiration (8) par l'intermédiaire d'un axe de support (58), et
il est configuré qu'un espace entre la surface d'ouverture supérieure de la base d'aspiration mobile (17) faisant face à la partie incurvée concavo-convexe (18) et le tamis d'aspiration (8) soit fermé par les plaques de protection (56) dans un état où la base d'aspiration mobile (17) est abaissée jusqu'à la position de transfert de pièces à travailler.

7. Dispositif de collage selon la revendication 6, dans lequel
les extrémités adjacentes des plaques de protection adjacentes (56) se chevauchent à l'intérieur et à l'extérieur, et
dans un état où la base d'aspiration mobile (17) est abaissée jusqu'à la position de transfert de pièces à travailler, le groupe de plaques de protection (56) sont suspendues en une position verticale par l'arbre de support (58), et l'espace entre la surface d'ouverture supérieure de la base d'aspiration mobile (17) et le tamis d'aspiration (8) est fermé dans un état où les extrémités adjacentes des plaques de protection (56) se chevauchent à l'intérieur et à l'extérieur.

8. Procédé de collage d'une première pièce à travailler (W1) aspirée et maintenue par une base d'aspiration supérieure (4) et d'une seconde pièce à travailler (W2) aspirée et maintenue par une base d'aspiration inférieure (6), qui est dotée d'une base d'aspiration fixe (16) comportant une structure de cadre fixée à une base (5), d'une base d'aspiration mobile (17) comportant une structure de cadre disposée autour de la base d'aspiration fixe (16), et d'un tamis d'aspiration (8) qui recouvre une surface d'ouverture supérieure de la base d'aspiration mobile (17), le procédé de collage comprenant les étapes consistant à :
aspirer et maintenir, avec la base d'aspiration supérieure (4), la première pièce à travailler (W1) préalablement moulée en une forme courbe concavo-convexe dans laquelle une surface incurvée saillante et une surface incurvée concave sont continues, par la base d'aspiration supérieure (4), et placer la seconde pièce à travailler (W2) sur le tamis d'aspiration (8) soutenu à plat par la base d'aspiration mobile (17) déplacée vers une position de soutien de pièce à travailler et aspirer et maintenir la seconde pièce à travailler (W2) ;
déplacer la base d'aspiration mobile (17) vers le bas jusqu'à une position de transfert de pièces à travailler pour déformer le tamis d'aspiration (8) en une forme courbe concavo-convexe suivant une forme courbe concavo-convexe d'une partie incurvée concavo-convexe (18) formée sur la base d'aspiration fixe (16), et déformer la seconde pièce à travailler (W2) aspirée et maintenue par le tamis d'aspiration (8) en la forme courbe concavo-convexe de la partie incurvée concavo-convexe (18) accompagnant la déformation du tamis d'aspiration (8) ;
amener la base d'aspiration supérieure (4) et la base d'aspiration inférieure (6) à se faire face verticalement pour faire correspondre les formes courbes concavo-convexes de la première pièce à travailler (W1) et de la seconde pièce à travailler (W2), et maintenir le long des formes courbes concavo-convexes un intervalle constant entre les pièces à travailler (W1 et W2) se faisant face ; et
coller la seconde pièce à travailler (W2) à la première pièce à travailler (W1) par déplacement du rouleau de collage (7) disposé à l'intérieur de la base d'aspiration fixe (16) depuis une extrémité de début de collage vers une extrémité de fin de collage par une structure de déplacement de rouleau dans un état où la seconde pièce à travailler (W2) est pressée contre la première pièce à travailler (W1) par élévation du rouleau de collage (7) d'une position d'attente à une position de pressage par une structure d'élévation et d'abaissement de rouleau,
dans lequel, dans l'étape de collage de la seconde pièce à travailler (W2) à la première pièce à travailler (W1), le rouleau de collage (7) est élevé et abaissé le long de la forme courbe concavo-convexe de la première pièce à travailler (W1) par la structure d'élévation et d'abaissement de rouleau pour coller la seconde pièce à travailler (W2) à la première pièce à travailler (W1) avec une force de pression uniforme.
